# EUROPEAN PATENT APPLICATION

(11) **EP 3 913 379 A1**
(43) Date of publication of application: **24.11.2021**
(21) Application number: 20175667.3
(22) Date of filing: 20.05.2020
(51) Int. Cl.: G01R 15/06, G01R 15/16, H01G 4/14, H01G 4/28, H01G 4/38

(54) **CAPACITOR ASSEMBLY**

(71) Applicant: 3M Innovative Properties Company, Saint Paul, MN 55133-3427 (US)
(72) Inventor: Stollwerck, Dr. Gunther, 47802 Krefeld (DE); Gravermann, Mark, 41812 Erkelenz (DE); Weichold, Mr. Jens, 41812 Erkelenz (DE)
(74) Representative: Müller, Bruno

(57) **Abstract**

Capacitor assembly (1) for a voltage divider for sensing an elevated voltage in a MV/HV power distribution network of a national grid. The capacitor assembly comprises a body (100) comprising a solidified, electrically insulating casting material (90) and an integrated primary capacitor (40), operable in a high-voltage portion of the voltage divider, comprising a low-voltage electrode (80) and an elongated high-voltage electrode (20).

The low-voltage electrode (80) is embedded in the casting material (90) and comprises a circumferential wall (50) forming an elongated cavity (30). The high-voltage electrode (20) is embedded in the casting material (90) and protrudes into the cavity (30). A portion of the casting material (90) is arranged in the cavity (30) between the low-voltage electrode (80) and the high-voltage electrode (20) such as to be operable as a dielectric of the primary capacitor (40).

The circumferential wall (50) comprises a mesh of conductive wires (190) forming a plurality of apertures (60) between the conductive wires to allow the casting material (90) outside the circumferential wall (50) to be mechanically connected with the casting material (90) in the cavity (30) while the casting material solidifies and thereafter.

## Description

This disclosure relates to voltage dividers for sensing an elevated voltage in medium-voltage or high-voltage power distribution networks of a national grid. In particular, it relates to capacitor assemblies useable in such voltage dividers and to sensors and insulation plugs containing such capacitor assemblies. The disclosure also relates to methods of manufacturing such capacitor assemblies.

For better control and better management of their networks, power network operators are upgrading their networks by adding more and more voltage sensors. Such sensors measure voltage between a power conductor on medium or high voltage and an element on electrical ground. Sensors of this kind are often mechanically attached to the power conductor and, on the other side, to an element on electrical ground, whereby a sensor can be easily added, i.e. retrofitted, to an existing network without having to make further changes.

An example of a retrofittable voltage sensor can be found in the European patent application EP 3 499 246 A1, in which a voltage divider assembly comprises a plurality of discrete impedance elements, operable as a high-voltage side of the voltage divider, and a cable connector.

In capacitive voltage dividers, the dividing capacitors are exposed to the elevated voltage of the power conductor and divide that elevated voltage, either in fewer and larger steps via a small number of "larger" capacitors, or in more, smaller steps via a greater number of "smaller" capacitors. While discrete capacitors are often used for the "smaller" capacitors, "larger" capacitors are often not discrete, but integrated capacitors, i.e. capacitors that are formed by structural elements of the sensor rather than by separate electrical elements.

In either case, the capacitors of the voltage divider require adequate electrical insulation in order to reduce the risk of electrical discharges between any capacitor on a high voltage and an element on lower voltage. Due to the strong electrical fields in the vicinity of the dividing capacitors of the high-voltage portion of the voltage divider, the insulating material must be a good insulator and provide a high barrier to discharges. Any void or bubble in the insulating material may give rise to partial discharges.

Embedding capacitors of a MV/HV voltage divider in a solidified casting material is a proven method of obtaining a strong, mostly void-free electrical insulation, with the added benefit of mechanical rigidity of the voltage divider. When manufacturing such a capacitor assembly, a liquid, viscous casting material flows around the capacitors in a mold, filling all available space and thus reducing formation of voids. The casting material is then caused to cure and thereby solidify.

Where a low-voltage electrode of an integrated capacitor comprises a contiguous circumferential wall forming an elongated cylindrical cavity, a viscous casting material can only flow into the elongated cavity through the apertures at the ends of the cavity. The smaller the apertures and the more viscous the casting material, the longer the casting process - and the higher the likelihood of the casting material not filling the entire available space and of voids forming inside the cavity. The resulting capacitor assembly will have a higher likelihood of electrical discharges at those voids, and thus be generally less reliable.

Upon solidification and curing of the casting material, the casting material shrinks, while the embedded electrode maintains its size, the electrode being mostly made from metal. This shrinkage tends to dissolve the bond between the casting material and the surface of the electrode, so that a gap may develop between the casting material and the electrode surface. Electrical discharges across the gap are likely to happen and will destroy the integrity of the capacitor assembly, thereby reducing its performance and reliability.

The recently published international patent application WO 2019/186607 A1 addresses similar problems. It suggests a capacitive voltage sensor comprising an electrode comprising a plurality of first elements having an elongated shape, arranged circumferentially side by side to form a tubular body and cantilevered with their distal ends joined to each other and their proximal ends free.

For better performance, i.e. less delamination upon solidification and less voids caused by inconsistent flow of the casting material, further improvement is desirable. It is also desirable to have a capacitor assembly at lower cost. It is further desirable to provide an electrode which is mechanically more stable.

The present disclosure attempts to address these needs. It provides a capacitor assembly for a voltage divider for sensing an elevated voltage in a MV/HV power distribution network of a national grid, the capacitor assembly comprising
a) a body comprising a solidified, electrically insulating casting material;
b) an integrated primary capacitor, operable in a high-voltage portion of the voltage divider, comprising a low-voltage electrode and an elongated high-voltage electrode;
wherein the low-voltage electrode is embedded in the casting material and comprises a circumferential wall forming an elongated cavity, wherein the high-voltage electrode is embedded in the casting material and protrudes into the cavity, wherein a portion of the casting material is arranged in the cavity between the low-voltage electrode and the high-voltage electrode such as to be operable as a dielectric of the primary capacitor, and wherein the circumferential wall comprises a mesh of conductive wires forming a plurality of apertures between the conductive wires to allow the casting material outside the circumferential wall to be mechanically connected with the casting material in the cavity while the casting material solidifies and thereafter.

During the casting process, when manufacturing the capacitor assembly, the large number of apertures in the mesh allow the casting material to flow through the apertures into the elongated cavity more reliably and more quickly. This reduces the likelihood of voids being created in the cavity during casting.

After the casting material solidifying, e.g. when the capacitor assembly is in use, the mesh apertures are filled with casting material, which results in the casting material outside the circumferential wall being connected and contiguous with the casting material in the cavity, i.e. inside the circumferential wall. The casting material in the mesh apertures forms "bridges" between the casting material radially outside the circumferential wall, i.e. outside the cavity, and the casting material radially inside the circumferential wall, i.e. in the cavity. Upon curing and solidification, when the casting material shrinks, the casting material is less likely to delaminate from the surface of the circumferential wall of the electrode, because the large number of "bridges" hold the casting material in place on both sides of the circumferential wall. The bridges thereby help avoid separation of the casting material from the low-voltage electrode and reduce the creation of gaps and voids between the casting material and the electrode.

A mesh electrode provides a higher degree of mechanical stability than, for example, elongated metal lamellae connected with each other at one end and free on their other end, because the wires of the mesh are interconnected in all portions of the mesh and thus in particular can provide stable edges of the circumferential wall which don't deform easily when a viscous casting material flows around the low-voltage electrode.

Also, conductive wire meshes are commercially available off the shelf, easier and at lower cost than a machined or custom-made structure of lamellae, making the capacitor assembly of the present disclosure more economical to produce.

The present disclosure relates to capacitor assemblies and voltage dividers for use in medium-voltage (MV) or high-voltage (HV) power distribution networks in which electrical power is distributed via HV/MV power cables, transformers, switchgears, substations etc. with currents of tens or hundreds of amperes and voltages of tens of kilovolts. The expression "medium voltage" or "MV" as used herein refers to AC voltages in the range of 1 kV to 72 kV, whereas the expression "high voltage" or "HV" refers to AC voltages of more than 72 kV. Medium voltage and high voltage are collectively referred to herein as "elevated voltage".

Capacitor assemblies according to the present disclosure are useful for sensing a voltage in a power distribution network with high accuracy. In particular they are useful as an element in the high-voltage portion of capacitive voltage dividers. The integrated primary capacitor of respective capacitor assemblies according to the present disclosure may be used as the only capacitor in the high-voltage portion of capacitive voltage dividers, e.g. as the only capacitor in a capacitive voltage divider which comprises a single capacitor in its high-voltage portion.

In certain embodiments, a capacitor assembly according to the present disclosure is connected electrically and mechanically to an element of a switchgear or of a transformer, wherein the element is on elevated voltage. A voltage divider is used to sense the elevated voltage of the element to a certain degree of precision, e.g. 10% or 5% or 1% precision. The voltage divider can comprise a capacitor assembly as described herein.

In certain of these embodiments the capacitor assembly is mechanically and electrically connected to an element on elevated voltage to which an MV/HV power cable is electrically connected via a cable termination. In these embodiments the voltage divider comprising the capacitor assembly can sense the elevated voltage of the power cable. Such a "standalone" arrangement of the voltage sensor may be easier to provide than a voltage sensor integrated into a cable termination.

As used herein, a high-voltage portion of a voltage divider is the electrical portion that is electrically arranged between a signal contact, at which a divided voltage can be picked up, and the elevated voltage which is to be sensed. Accordingly, the low-voltage portion of a voltage divider is the portion that is electrically arranged between that signal contact and electrical ground.

In a capacitive voltage divider, the high-voltage portion comprises one or more capacitors ("high-voltage capacitors"), and the low-voltage portion comprises one or more capacitors ("low-voltage capacitors"). The primary capacitor of the capacitor assembly according to the present disclosure is one of the high-voltage capacitors. Where the high-voltage portion comprises only one high-voltage capacitor, the primary capacitor of the capacitor assembly according to the present disclosure is this high-voltage capacitor.

In certain embodiments a capacitor assembly according to the present disclosure comprises one low-voltage capacitor, or a plurality of low-voltage capacitors. A low-voltage capacitor may be a discrete capacitor or an integrated capacitor. The low-voltage capacitor(s) may, for example, be embedded in the casting material or attached to the body of the capacitor assembly. It may be advantageous for the capacitor assembly to comprise the low-voltage capacitor(s) because this may increase reliability of the voltage divider, since no error-prone external wire connection between the primary capacitor and the low-voltage capacitor(s) is required and the connection between the primary capacitor and the low-voltage capacitor(s) may be shorter and is less likely to pick up noise.

Therefore, in certain embodiments the capacitor assembly further comprises at least one low-voltage capacitor comprised in a low-voltage portion of the voltage divider and electrically connected in series to the primary capacitor.

The term "integrated capacitor" is used in this disclosure as referring to a capacitor which is formed by structural elements of a larger entity or of which at least portions are formed by structural elements of a larger entity. An example of an integrated capacitor is a capacitor formed by two conductive traces on opposite sides of a printed circuit board. As stated above, "integrated capacitor" is expressly meant to not refer to discrete capacitors. Discrete capacitors are capacitors which exist independently from structural elements of a larger entity at some stage and can be commercially obtained individually and separately from other elements and separate from structural elements.

A capacitor assembly according to the present disclosure has a body comprising a solidified, electrically insulating casting material. In certain embodiments the body is formed by the solidified, electrically insulating casting material.

The body may form a substantial portion of the capacitor assembly, such as at least 30% of the volume of the capacitor assembly, or at least 50% of the volume of the capacitor assembly. The body may be adapted to provide structural rigidity to the capacitor assembly. A thin layer or a coating is not considered a body of the capacitor assembly.

The casting material is an electrically insulating material. It is flowable, i.e. liquid or viscous, when manufacturing the body, so that during a casting process it can flow through the apertures of the circumferential wall into the elongated cavity, e.g. into an inter-electrode space between the low-voltage electrode and the high-voltage electrode.

The casting material can then be solidified, i.e. hardened. Its solidification results in a hard and rigid casting material and consequently in a rigid body of the primary capacitor. The casting material may solidify, for example, by curing. Curing may be effected by drying at room temperature or in an oven, or it may be effected by exposing the casting material to radiation, such as ultraviolet radiation or electron beam radiation. The casting material may contain a curing agent.

In certain embodiments the casting material is flowable at temperatures of 20°C or more. Such casting materials may, for example, solidify by evaporation of its constituents or it may solidify, for example, by a forced curing process, such as UV curing or electron beam curing. In certain other embodiments the casting material may be flowable at temperatures of 80°C or more, or 100°C or more. Such casting materials may, for example, solidify by cooling to a lower temperature, e.g. to temperatures of 30°C or lower.

In certain advantageous embodiments the space in the elongated cavity between the low-voltage electrode and the high-voltage electrode, i.e. the "inter-electrode space", is completely filled with solidified casting material. The complete fill helps provide better mechanical stability of the circumferential wall and avoids the existence of unfilled pockets, gaps or voids through which partial discharges could occur.

Hence, in certain embodiments, the space in the elongated cavity between the low-voltage electrode and the high-voltage electrode is completely filled with solidified casting material.

In other embodiments, the inter-electrode space is partially filled with solidified casting material. In some of those other embodiments, the inter-electrode space is filled with solidified casting material and one or more other materials. In these embodiments, the solidified casting material and the one or more other materials may be each operable as a dielectric of the primary capacitor.

The casting material may be, or may comprise, an epoxy resin or a polyurethane resin. The casting material may be a mixture of a resin material with one or more filler materials. Filler materials may be, for example, SiO₂ or Al₂O₃ or a ceramic material.

Before it solidifies, the casting material is in a liquid or viscous state, so that it can flow through the apertures formed by the mesh of conductive wires into the elongated cavity within a time frame that is reasonable for an industrial production process, e.g. a few seconds up to a minute or several minutes. Viscosity of a casting material may depend on its temperature. For an industrial production process, it is advisable to select a casting material that has a sufficiently low viscosity to be flowable at an operating temperature of the casting process. An operating temperature of a suitable casting process for casting the body may be, for example, about 25°C or about 50°C or about 100°C or about 130°C.

Where the mesh of conductive wires of the circumferential wall forms comparatively small apertures, the flowability of the casting material must be generally higher to flow into the elongated cavity and its viscosity lower, whereas a higher-viscosity casting material may flow through apertures in a reasonable time if these apertures are larger. Viscosities above 20'000 mPa.s at 20°C appear generally not suitable for the casting material during an industrial casting process.

After solidifying, i.e. after curing or hardening, the casting material typically imparts its mechanical properties to the body. In order to protect the low-voltage electrode and the high-voltage electrode embedded in the casting material against mechanical stress, it is desirable that the body be rigid. Hence the solidified casting material may be a solid, rigid material.

The low-voltage electrode of the primary capacitor is electrically connected to the low-voltage portion of the voltage divider. It is therefore on a lower voltage than the high-voltage electrode, which is electrically connected to the elevated voltage which is to be measured. In certain embodiments, the low-voltage electrode is electrically connected to a low-voltage capacitor.

The conductive wires of the mesh of the circumferential wall may be made of metal, such as, for example, steel, copper, aluminium, gold, or silver. The thickness of the mesh may be, for example, between about 0,1 mm and about 5 mm, preferably between about 0,2 mm and about 2 mm. Thicker meshes may be harder to bring into the desired shape and may add to weight of the capacitor assembly more than necessary. The apertures are arranged in the mesh such as to form through-holes through the thickness of the mesh. Wires forming the mesh may have diameters, for example, of 0,05 mm or more, 0,2 mm or more, 0,5 mm or more, 1,0 mm or more and up to a few millimeters.

The low-voltage electrode and/or the circumferential wall may have a generally cylindrical shape. The inner diameter of the cavity formed by the circumferential wall is adapted such that the high-voltage electrode can protrude deep into the cavity and such that in a concentric arrangement of the low-voltage electrode and the high-voltage electrode the radial distance between the inner surface of the low-voltage electrode and the outer surface of the high-voltage electrode is large enough to prevent electrical discharges between the electrodes through the casting material.

The diameter of the elongated cavity is advantageously chosen such that it can accommodate the portion of the high-voltage electrode protruding into it, and such that the primary capacitor has a larger capacitance. Generally, the capacitance is larger if the distance between the electrodes is smaller. Too small a distance will, however, increase the risk of discharges through the dielectric, i.e. through the solidified casting material. The diameter of the cavity will also depend on the peak value of the elevated voltage. In certain typical advantageous embodiments, the diameter of the elongated cavity is between 20 millimeters and about 80 millimeters.

In certain advantageous embodiments the circumferential wall has a generally cylindrical shape, and also the high-voltage electrode protruding into the cavity formed by the low-voltage electrode (or at least the portion of the high-voltage electrode protruding into the cavity) has a generally cylindrical shape. In some of those embodiments the circumferential wall is arranged concentrically around the high-voltage electrode (or around the portion of the high-voltage electrode protruding into the cavity). A concentric arrangement can provide for an even distance between the electrodes, which helps avoid electrically weak areas with higher electrical stress where electrical discharges are more likely to occur. This, in turn, may allow for a smaller overall size of the capacitor assembly and enhanced reliability.

Therefore, in certain embodiments, the circumferential wall has a generally cylindrical shape, and the high-voltage electrode has a generally cylindrical shape, and the circumferential wall is arranged concentrically around at least a portion of the high-voltage electrode.

In concentric electrode arrangements, electrical stress is more evenly distributed around the circumference of the respective electrodes. Due to this even distribution, the electrodes can be operated at a smaller overall distance between each other, which often allows for a smaller overall size of the capacitor assembly. The flow of casting material through the apertures into the cavity may reduce the number of voids in the body of the primary capacitor and thereby may allow for higher field strengths without creating an unacceptably high risk of discharges. Depending on, inter alia, the elevated voltage and the electrical properties of the casting material, the radial distance between the circumferential wall of the low-voltage electrode and the high-voltage electrode may be 50 millimeters or less or even 20 millimeters or 15 millimeters or less, while in typical embodiments this distance is between 1 millimeter and 10 millimeters. This radial distance is measured in a direction orthogonal to the central axis of the concentric arrangement and between the outer surface of the high-voltage electrode and the inner surface of the circumferential wall. Hence in certain embodiments a radial distance between the circumferential wall and the high-voltage electrode is 50 millimeters or less.

A generally cylindrical shape of the circumferential wall may be a cylindrical shape formed by a plurality of flat segments. The cross section of such a cylindrical circumferential wall may resemble a polygon, such as an octagon or a hexagon, a rectangle, a square or even a triangle.

Independent of its cross section, the circumferential wall extends circumferentially generally about a full 360° circumference, so that the cavity is delimited by the circumferential wall at all points of the circumference, except for where the apertures of the mesh are located.

It is desirable to keep the spatial relationship between the high-voltage electrode and the circumferential wall stable during the casting process when the casting material flows into the cavity, possibly with some pressure. Therefore, in certain embodiments, a capacitor assembly according to the present disclosure further comprises a spacer for maintaining the circumferential wall in a fixed position relative to the high-voltage electrode or relative to the body.

The circumferential wall may not have a cylindrical shape but may have the shape of a funnel. A funnel shape of the circumferential wall may be a funnel shape formed by a plurality of flat segments. The cross section of such a funnel-shaped circumferential wall may resemble, for example, a circle or an ellipse, a polygon, such as an octagon or a hexagon, a rectangle, a square or a triangle.

The circumferential wall of the low-voltage electrode forms an elongated cavity. The cavity is thus delimited by the circumferential wall. The cavity is elongated and may thereby define length directions. Radial directions are directions perpendicular to a length direction. The cavity may comprise a first end portion and a second end portion, the first and the second end portions being opposed to each other in length direction. The high-voltage electrode may protrude into the cavity at the first end portion. At the opposed second end portion, the cavity may be open. Alternatively, at the opposed second end portion, the cavity may be closed, e.g. by a face wall. The face wall may be conductive or non-conductive. A conductive face wall may comprise, for example, a conductive mesh or a conductive end plate.

Closing the cavity by a face wall at the second end portion may help prevent deformation of the circumferential wall during the casting process or during solidification. Closing the cavity by a conductive face wall at the second end portion may, in addition, yield a higher capacitance of the primary capacitor. Therefore, in certain embodiments, the low-voltage electrode comprises a face wall closing an end portion of the elongated cavity.

The elongated cavity is delimited radially by the circumferential wall. Hence the shape of the circumferential wall determines the shape of the cavity. The cross section of the elongated cavity may have the shape, for example, of a polygon, such as an octagon or a hexagon, a rectangle, of a square or even a triangle. Alternatively, the elongated cavity may have, for example, a cylindrical shape. Alternatively, the cross section of the elongated cavity may have the shape of a circle or of an ellipsis, or it may have an oval shape.

In a specific embodiment, the circumferential wall has a cylindrical shape and forms a cylindrical elongated cavity which is closed at the second end portion.

The diameter of the elongated cavity may vary along its length direction. Hence the cavity may have the shape of a funnel. The cross section of a funnel-shaped elongated cavity may have the shape of a polygon, such as an octagon or a hexagon, a rectangle, a square or even a triangle. Alternatively, the elongated cavity may have, for example, a conical shape. Alternatively, the cross section of the funnel-shaped elongated cavity may have the shape of a circle or of an ellipsis, or it may have an oval shape.

A circumferential wall may be shaped such as to form an elongated cavity that is axially symmetric about an axis which is parallel to its length direction. Alternatively, however, the elongated cavity may not be axially symmetric. In certain embodiments, the elongated cavity is not straight in its general length direction, but it is curved in its general length direction.

Both the low-voltage electrode and the high-voltage electrode of the primary capacitor are embedded in the casting material. In particular, the mesh of conductive wires of the circumferential wall of the low-voltage electrode is embedded in the casting material. As used herein, an element is "embedded" in a material if it is surrounded on all sides by that material.

A portion of the low-voltage electrode, such as the mesh of conductive wires of the circumferential wall, may be in surface contact with a portion of the solidified casting material. The conductive wires of the mesh of conductive wires of the circumferential wall may be in surface contact with the solidified casting material.

Where the circumferential wall has a cylindrical shape, its outer curved surface (i.e. its surface facing away from the cavity) may be in surface contact with the solidified casting material. Alternatively, or in addition, the inner curved surface of the circumferential wall (i.e. its surface facing towards the elongated cavity) may be in surface contact with the solidified casting material.

Turning now to the high-voltage electrode of the primary capacitor, this electrode protrudes into the elongated cavity formed by the circumferential wall. It is electrically connectable, or connected, with an element on the elevated voltage which the voltage divider is to sense. This electrical connection may be an ohmic connection. The high-voltage electrode may be electrically directly connectable or directly connected with an element on the elevated voltage which the voltage divider is to sense. A direct connection is a connection without any additional electrical elements being electrically arranged between the high-voltage electrode and the element on elevated voltage, i.e. without any resistors, capacitors, or inductors. A direct electrical connection implies that the high-voltage electrode "sees" (is exposed to) the full elevated voltage.

The high-voltage electrode of the primary capacitor is on the elevated AC voltage, while the low-voltage electrode is on a considerably lower voltage, so that parasitic currents flow through the casting material, which can be described by "parasitic capacitances". In typical capacitor assemblies for elevated voltages of about 50 kV, these parasitic capacitances are typically between 1 and 10 pF (picofarad), and they vary with the temperature of the casting material. For precise voltage measurement, the capacitance of the primary capacitor - or generally of the high-voltage portion of the voltage divider - should be clearly greater than these 1-10 pF, so that the signal voltage is not influenced greatly by variations of the parasitic capacitances. A capacitance of the primary capacitor which is clearly larger than 10 pF is therefore desirable. Also, the voltage divider is usually connected to a voltage measurement device which senses the divided voltage and determines the elevated voltage from the divided voltage. A higher capacitance of the primary capacitor is desirable in order to reduce the influence of the input impedance of the voltage measurement device and to thereby provide for a higher accuracy in sensing the elevated voltage.

The high-voltage electrode should maintain its shape during the casting process, so that it maintains a suitable distance to the low-voltage electrode. It is therefore desirable that the high-voltage electrode be rigid. To reduce concentration of electrical field lines at the high-voltage electrode and the electrical stress associated therewith, a generally cylindrical shape of a not-too-small diameter is deemed useful, such as the shape of a cylindrical rod. Therefore, in certain embodiments of the capacitor assembly described herein the high-voltage electrode comprises a rigid conductive rod. The rod may be solid or hollow.

To further reduce electrical stress in the strong field between the low-voltage electrode and the high-voltage electrode, the conductive rod may be provided with a rounded end portion.

A capacitor assembly according to the present disclosure may be, or it may be comprised in, an insulation plug. Such insulation plugs are used to fill and electrically insulate an access cavity in a separable connector by which a power cable can be connected to a bushing, e.g. of a switchgear or of a transformer in a power distribution network, e.g. a national grid. An insulation plug has a shape that corresponds to the shape of the cavity which it is supposed to fill. Often, the cavity and the insulation plug have a shape of a truncated cone. These insulation plugs may have, for example, a conductive threaded contact piece, e.g. of copper, for mechanical and electrical connection to an element of the separable connector on elevated voltage. The contact piece may be electrically connected to the high-voltage electrode of the capacitor assembly, so that the elevated voltage can be sensed using the capacitor assembly. Alternatively, the contact piece may be, or may comprise, the high-voltage electrode of the capacitor assembly.

Hence, in one aspect, the present disclosure also provides an insulation plug, insertable into a cavity of a separable connector in a power distribution network for distributing electrical power at medium or high voltages, and comprising a capacitor assembly as described herein. In such embodiments the low-voltage electrode and the portion of the high-voltage electrode protruding into the low-voltage electrode may be embedded in the body of the insulation plug.

In such embodiments the insulation plug may be adapted such that the high-voltage electrode can be electrically connected to an element of the separable connector on elevated voltage.

For higher precision in voltage sensing it is generally desirable for the primary capacitor to have a higher capacitance. Therefore, the high-voltage electrode protrudes into the elongated cavity far enough for the high-voltage electrode and the low-voltage electrode to maximize the capacitance of the primary capacitor, within certain limits imposed by safety, reliability, space and manufacturability. In certain preferred embodiments, the high-voltage electrode protrudes into the elongated cavity by more than 50% of the length of the cavity, in other embodiments by more than 80% or more than 90% of the length of the cavity.

The high-voltage electrode may be a conductive cylindrical rod. Its diameter may be, for example, between 1 mm and 50 mm, preferably between 20 mm and 40 mm. A first end portion of a rod-shaped high-voltage electrode may be arranged in the elongated cavity. The first end portion may be hemispherical or generally curved. This would be to avoid sharp edges and a concentration of electrical field lines at such edges. The high-voltage electrode may be made from, or comprise, metal.

In embodiments where the capacitor assembly is, or is comprised in, an insulation plug for a separable connector, the high-voltage electrode may be a portion of a contact piece via which the insulation plug can be connected to an element of the separable connector on elevated voltage. In such embodiments the high-voltage electrode may have, for example, a cylindrical shape or a conical shape.

The shape of the apertures formed by the mesh of conductive wires of the circumferential wall is not particularly limited. An aperture, or a plurality of apertures, or all apertures may have a circular shape, an elliptical, an oval, a square, a rectangular, a hexagonal, a polygonal or a triangular shape, for example.

A more viscous casting material will generally require larger apertures to flow reliably through the apertures into the elongated cavity. Hence the size of a larger number of apertures is advantageously chosen such that the combination of aperture size and viscosity allows for a flow of the casting material to reliably fill the cavity completely within an acceptable time.

A portion of the casting material advantageously fills each aperture, or at least a plurality of apertures, and thereby mechanically connects, through the apertures, casting material outside the circumferential wall with casting material in the cavity, i.e. inside the circumferential wall. This connection generally helps reduce the risk of gaps or voids or delamination being created upon thermal cycling or upon potential shrinkage of the casting material during solidification or thereafter. Larger apertures generally improve the connection between the portion of the casting material outside the circumferential wall and the portion of the casting material inside the circumferential wall, where a better connection reduces the risk of delamination between the portions during solidification and curing of the casting material.

Hence in certain embodiments each aperture of the plurality of apertures is filled with a portion of the casting material.

For viscosities of the casting material of less than 20'000 mPa.s at 60°C, the size of the apertures may advantageously be chosen to be at least about 0,1 mm in their shortest extensions. In certain embodiments the size of the apertures is more than 0,5 mm, or more than 1 mm, in their shortest extension. The extension of an aperture as used herein is measured along the surface of the mesh of conductive wires, not in the thickness direction of the mesh, i.e. not orthogonal to the surface of the mesh.

Within the limits outlined above, it is generally preferred for the circumferential wall to have more smaller apertures, as opposed to fewer larger apertures. Taking into account typical sizes and distances for components exposed to high and medium voltages, in certain embodiments of a capacitor assembly according to the present disclosure, each aperture has a longest extension of 10 millimeters or less.

Besides the size of the apertures it is also the number of apertures in the mesh of conductive wires which determines how reliably the casting material can flow into the cavity, and how well the portion of the casting material outside the circumferential wall is connected with the portion of the casting material inside the cavity. Under these aspects more apertures are desirable but reducing the surface of the low-voltage electrode by having more apertures typically reduces the capacitance of the primary capacitor, increases field strength at the edges of the apertures and weakens the structure of the circumferential wall of the low-voltage electrode.

In certain embodiments, the plurality of apertures comprises at least one hundred apertures or at least one thousand apertures. Depending on the choice of viscosity of the casting material and the size of the apertures, hundred apertures is deemed to be a typical minimum number of apertures for ensuring adequate contact between casting material outside the circumferential wall and casting material inside the cavity. In certain other embodiments, however, the plurality of apertures comprises ten or more apertures , or fifty or more apertures.

In balancing these requirements, a few tens, or a few hundreds up to a few thousands of apertures may be an acceptable choice for capacitor assemblies in which the elongated cavity has a length of between 10 cm and 50 cm and a diameter of between 1 cm and 10 cm.

The apertures may generally be positioned randomly in the circumferential wall. However, in order to provide for a good coherence between portions of the casting material outside the circumferential wall and portions of the casting material inside the circumferential wall in all parts of the circumferential wall, in certain preferred embodiments the apertures are evenly distributed over the mesh of conductive wires of the circumferential wall. An even distribution relates to approximately the same number of apertures per unit area of the circumferential wall.

Too many large apertures may weaken the circumferential wall and reduce the capacitance of the primary capacitor. It is conceived that in certain advantageous embodiments the apertures account for less than about 80% of the continuous surface of the mesh of conductive wires of the circumferential wall. "Continuous surface" refers to the imaginary surface of the mesh if no apertures were present. In other advantageous embodiments the apertures account for less than about 50% of the continuous surface of the mesh, in certain other embodiments the apertures account for less than about 30% of the continuous surface of the mesh.

The capacitor assembly disclosed herein can be manufactured cost-effectively and is useful for reliably sensing voltages in MV/HV power distribution networks. Voltage sensors are preferably placed in electrical apparatus of the network, such as in switchgears or in transformers. The capacitor assembly can be connected electrically to a power conductor on elevated voltage in such apparatus to sense the voltage of the power conductor, e.g. versus ground or versus another phase. Therefore, the present disclosure also provides a power distribution network for distributing electrical power at medium or high voltages, the network comprising
a) an electrical apparatus, such as a switchgear or a transformer, having a power conductor for conducting the electrical power, the power conductor being on elevated voltage when in use; and
b) a voltage divider for sensing the elevated voltage and comprising a capacitor assembly as described herein, wherein the high-voltage electrode is electrically connected to the power conductor.

The present disclosure also provides a process for making a capacitor assembly as described herein. In an exemplary manufacturing process, the low-voltage electrode and the high-voltage electrode as described above are provided and at least a portion of the high-voltage electrode is inserted into the cavity formed by the circumferential wall of the low-voltage electrode. These electrodes form the electrodes of an integrated primary capacitor for a high-voltage portion of a voltage divider.

Subsequently, the body of the integrated primary capacitor is formed in a casting process, and the low-voltage electrode and the high-voltage electrode are embedded in the flowable, uncured casting material of the body. In this casting process, viscous or liquid casting material flows into the cavity through the apertures of the mesh of conductive wires of the circumferential wall, as described above. Eventually the casting material solidifies to form at least a portion of the body. Some of the solidified casting material forms a dielectric of the primary capacitor between the electrodes. Due to the apertures in the circumferential wall, this process yields a capacitor assembly in a quick and hence cost-effective way, in which the dielectric is less likely to contain gaps or voids, and the solidified casting material is less likely to delaminate from the circumferential wall and create gaps between the low-voltage electrode and the dielectric of the primary capacitor.

Hence the present disclosure further provides a process of making a capacitor assembly as described herein, comprising the steps, in this sequence, of
a) providing a low-voltage electrode comprising a circumferential wall forming an elongated cavity, the circumferential wall comprising a mesh of conductive wires forming plurality of apertures between the conductive wires to allow a casting material outside the circumferential wall to be mechanically connected with the casting material in the cavity while the casting material solidifies and thereafter; and
b) embed the low-voltage electrode in an electrically insulating flowable, solidifiable casting material by making the casting material flow into the cavity through the apertures.

The capacitor assembly according to the present disclosure will now be described in more detail with reference to the following Figures exemplifying particular embodiments:
- Fig. 1: Perspective view of a first capacitor assembly according to the present disclosure;
- Fig. 2: Circuit diagram of a voltage divider comprising a capacitor assembly according to the present disclosure.

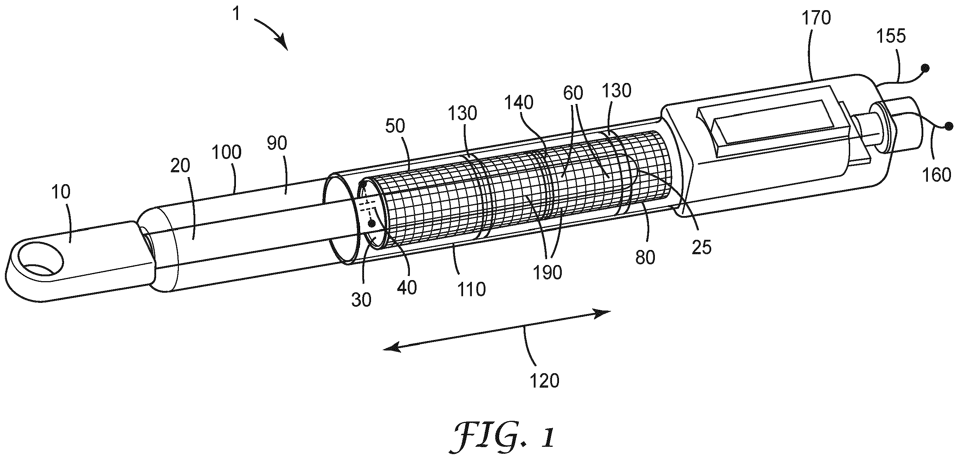

**Figure** 1 illustrates, in a perspective view, a first capacitor assembly 1 according to the present disclosure. For enhanced clarity, some elements are drawn as if they were transparent. The first capacitor assembly 1 is to be connected electrically and mechanically to an element on elevated voltage of about 30 kilovolt (kV) via a conductive lug portion 10, e.g. to a busbar in a switchgear in a medium-voltage power distribution network of a national grid.

The lug portion 10 is attached and conductively connected to a conductive metal rod 20 of cylindrical shape. The rod 20 is the high-voltage electrode 20 of a primary capacitor 40 of the capacitor assembly 1, indicated in dotted lines. The low-voltage electrode 80 of the primary capacitor 40 is formed by a circumferential wall 50 of a mesh of conductive wires 190 forming apertures 60 between the wires 190. The high-voltage electrode 20 protrudes deep into an elongated cavity 30 formed by the circumferential wall 50 of the low-voltage electrode 80. The high-voltage electrode rod 20 is provided with a rounded end portion 25 which is deemed helpful in avoiding electrical stress in that area that would otherwise occur through a high concentration of field lines.

The apertures 60 of the mesh have an extension, i.e. an open size, of about 0.5 mm, allowing, in manufacturing, a flowable solidifiable casting material 90 to flow into the elongated cavity 30 before the casting material 90 solidifies. During and after solidification, the casting material 90 fills the apertures 60, so that the casting material 90 in the apertures 60 mechanically connects the casting material 90 outside the circumferential wall 50 with the casting material 90 inside the cavity 30, i.e. inside the circumferential wall 50 while the casting material solidifies and thereafter.

The mesh openings 60 account for about 50% of the continuous surface of the circumferential wall 50, where "continuous surface" refers to the imaginary surface of the circumferential wall 50 if the mesh had no apertures 60.

The high-voltage electrode 20 and the low-voltage electrode 50 are embedded in the casting material 90 which forms a body 100 of the capacitor assembly 1. A portion of the casting material 90 is arranged in the cavity 30, between the high-voltage electrode 20 and the low-voltage electrode 80 and is operable as a dielectric of the primary capacitor 40. In the embodiment shown, the inter-electrode space in the cavity 30, i.e. the space between the high-voltage electrode 20 and the low-voltage electrode 80, is completely filled with casting material 90, so that no gaps or voids exist in the cavity 30.

The outer surface of the body 100 is provided with a conductive grounding layer 110 which extends far enough in a length direction 120 of the elongated cavity 30 to surround the circumferential wall 50 over its entire length. The grounding layer 110 is a layer of coated copper. It can be connected to electrical ground and may be used for shielding the primary capacitor 40. In alternative embodiments, not shown here, the grounding layer 110 may be formed by a further mesh of conductive wires, applied over the outer surface of the body 100.

During the casting process to manufacture the capacitor assembly 1, the relative positions of the low-voltage electrode 80, of the high-voltage electrode 20 and of the body 100 must be maintained. For that purpose, spacers130, 140 are used which remain in the capacitor assembly 1 after manufacturing: Two ring-shaped exterior spacers 130 maintain the position of the circumferential wall 50 and the entire low-voltage electrode 80 relative to the outer surface of the body 100. An interior spacer 140 maintains the position of the high-voltage electrode rod 20 relative to the low-voltage electrode 80.

The spacers 130, 140 are made from FR4, which is an electrically insulating material, and are provided with large holes (not shown) to allow flow of the casting material through the spacers 130, 140 into all portions of the cavity 30 with little obstruction.

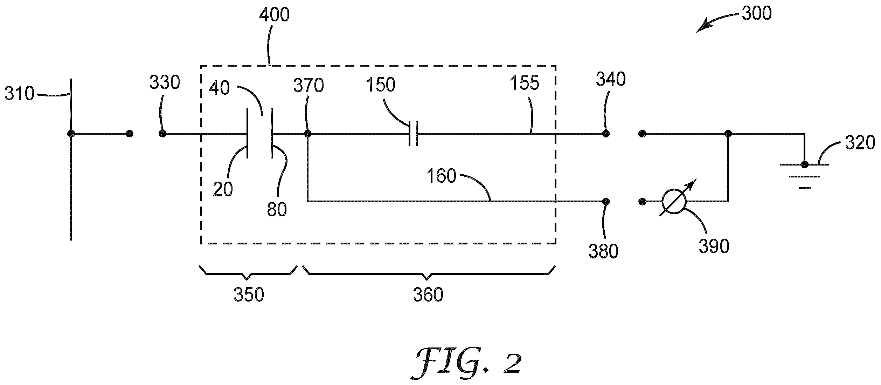

Referring now also to Figure 2 explained in detail below, in the capacitor assembly 1 of Figure 1 the primary capacitor 40 is the only capacitor of the high-voltage portion 350 of a voltage divider 300 for sensing the elevated voltage. The capacitor assembly 1 comprises a low-voltage capacitor 150 (not visible in Figure 1), electrically connected between the primary capacitor 40 and ground 320 and thereby forming a low-voltage side 360 of the voltage divider 300 for sensing the elevated voltage. This low-voltage capacitor 150 can be connected to electrical ground 320 via a grounding wire 155.

The low-voltage capacitor 150 is accommodated in a circuit box 170 which is attached to the body 100.

A divided voltage can be picked up at the low-voltage electrode 80. This divided voltage, also referred to as the "signal voltage" herein, varies proportionally with the elevated voltage, the proportionality factor being essentially determined by the dividing ratio of the voltage divider, i.e. its ratio of total impedance of the high-voltage portion to total impedance of the low-voltage portion. The elevated voltage can thus be sensed by determining the signal voltage and multiplying it with the proportionality factor. The signal voltage is made available outside of the capacitor assembly 1 via a signal wire 160.

It is noted that in other alternative embodiments, however, the capacitor assembly 1 does not comprise any low-voltage capacitor. In those alternative embodiments the low-voltage portion of the voltage divider is arranged remote from the capacitor assembly 1, and the primary capacitor 40 may be electrically connected to a remote low-voltage portion 360 e.g. by a cable or a wire. In these embodiments, the high-voltage portion 350 of the voltage divider 300 for sensing the elevated voltage is formed by the capacitor assembly 1, and the low-voltage portion 360 is arranged remotely from the high-voltage portion 350.

To increase an impulse withstand voltage of the capacitor assembly 1, its body 100 and the attached circuit box 170 may be enveloped by an electrically insulating silicone tube with a high relative permittivity, and with or without skirts to enhance track resistance.

**Figure** 2 is a circuit diagram of a capacitive voltage divider 300 for sensing an elevated AC voltage of a power conductor in a MV/HV power distribution network in which a capacitor assembly as described herein, like the capacitor assembly 1 shown in Figure 1 can be used. The voltage divider 300 is for connection between a power conductor 310 on elevated voltage in an electrical apparatus of the network (e.g. a busbar in a switchgear or in a transformer) and electrical ground 320, so it has a high-voltage contact 330 for connection to the elevated voltage and a grounding contact 340 for connection to ground 320.

The voltage divider 300 comprises a high-voltage portion 350 and a low-voltage portion 360. A divided voltage, the "signal voltage", can be picked up at a signal contact 370, electrically arranged between the high-voltage portion 350 and the low-voltage portion 360. The signal voltage is made available at an output contact 380 outside the voltage divider 300 via a signal wire 160.

The high-voltage portion 350 consists of a single capacitor which is the primary capacitor 40 with its high-voltage electrode 20 connected - in use - to the power conductor 310 on elevated voltage, and its low-voltage electrode 80. The low-voltage portion 360 in turn consists of one low-voltage capacitor 150, serially connected with the primary capacitor 40. Other capacitor assemblies according to the present disclosure may comprise two or more low-voltage capacitors 150, electrically connected in series or parallel to each other.

The signal voltage varies proportionally with the elevated voltage, the proportionality factor being essentially determined by the dividing ratio of the voltage divider 300, i.e. by the ratio of total impedance of the high-voltage portion 350 to total impedance of the low-voltage portion 360, with the total impedances being calculated on the basis of the capacitance values of the primary capacitor 40 and the low-voltage capacitor 150. The elevated voltage can thus be sensed by determining the signal voltage and multiplying it with the proportionality factor. A voltage measurement device 390 can be connected between output contact 380 and ground 320 to measure the signal voltage.

The voltage divider 300 is shown in an unconnected state, with the high-voltage contact 330 not connected to the power conductor 310, the grounding contact 340 not connected to ground 320, and the output contact 380 not connected to the voltage measurement device 390 yet.

The first capacitor assembly 1 of Figure 1 contains the elements of the voltage divider 300 around which a dotted-line box 400 is drawn in Figure 2. As stated above, alternative capacitor assemblies according to the present disclosure may contain only the primary capacitor 40 and no low-voltage capacitor 150. Yet alternative capacitor assemblies may have a high-voltage portion 350 comprising, beyond the primary capacitor 40, one or more further capacitors.

## Claims

1. Capacitor assembly (1) for a voltage divider (300) for sensing an elevated voltage in a MV/HV power distribution network of a national grid, the capacitor assembly com prising
a) a body (100) comprising a solidified, electrically insulating casting material (90);
b) an integrated primary capacitor (40), operable in a high-voltage portion (350) of the voltage divider, comprising a low-voltage electrode (80) and an elongated high-voltage electrode (20);
wherein the low-voltage electrode (80) is embedded in the casting material (90) and comprises a circumferential wall (50) forming an elongated cavity (30);
wherein the high-voltage electrode (20) is embedded in the casting material (90) and protrudes into the cavity (30);
wherein a portion of the casting material (90) is arranged in the cavity (30) between the low-voltage electrode (80) and the high-voltage electrode (20) such as to be operable as a dielectric of the primary capacitor (40), and
wherein the circumferential wall (50) comprises a mesh of conductive wires (190) forming a plurality of apertures (60) between the conductive wires to allow the casting material (90) outside the circumferential wall (50) to be mechanically connected with the casting material (90) in the cavity (30) while the casting material solidifies and thereafter.

2. Capacitor assembly according to claim 1, wherein the plurality of apertures (60) comprises at least one hundred apertures (60) or at least one thousand apertures (60).

3. Capacitor assembly according to claim 1 or claim 2, wherein each aperture (60) has a longest extension of 10 millimeters or less.

4. Capacitor assembly according to any one of the preceding claims, wherein each aperture of the plurality of apertures (60) is filled with a portion of the casting material (90).

5. Capacitor assembly according to any one of the preceding claims, wherein the circumferential wall (50) has a generally cylindrical shape, wherein the high-voltage electrode (20) has a generally cylindrical shape, and wherein the circumferential wall (50) is arranged concentrically around at least a portion of the high-voltage electrode (20).

6. Capacitor assembly according to claim 5, wherein a radial distance between the circumferential wall (50) and the high-voltage electrode (20) is 50 millimeters or less.

7. Capacitor assembly according to any one of the preceding claims, wherein the diameter of the elongated cavity (30) is between 20 millimeters and about 80 millimeters.

8. Capacitor assembly according to any one of the preceding claims, wherein the high-voltage electrode (20) comprises a rigid conductive rod, optionally provided with a rounded end portion (25).

9. Capacitor assembly according to any one of the preceding claims, further comprising a spacer (130, 140) for maintaining the circumferential wall (50) in a fixed position relative to the high-voltage electrode (20) or relative to the body (100).

10. Capacitor assembly according to any one of the preceding claims, wherein the low-voltage electrode (80) comprises a face wall (70) closing an end portion of the elongated cavity (30).

11. Capacitor assembly according to any one of the preceding claims, further comprising at least one low-voltage capacitor (150) comprised in a low-voltage portion (360) of the voltage divider (300) and electrically connected in series to the primary capacitor (40).

12. Capacitor assembly according to any one of the preceding claims, wherein the space in the elongated cavity (30) between the low-voltage electrode (80) and the high-voltage electrode (20) is completely filled with solidified casting material (90).

13. Insulation plug, insertable into a cavity of a separable connector in a power distribution network for distributing electrical power at medium or high voltages, and comprising a capacitor assembly (1) according to any one of the preceding claims.

14. Power distribution network for distributing electrical power at medium or high voltages, the network comprising
a) an electrical apparatus, such as a switchgear or a transformer, having a power conductor (310) for conducting the electrical power, the power conductor being on elevated voltage when in use; and
b) a voltage divider (300) for sensing the elevated voltage and comprising a capacitor assembly (1) according to any one of claims 1-12, wherein the high-voltage electrode (20) is electrically connected to the power conductor (310).

15. Process of making a capacitor assembly (1) according to any one of claims 1-12, comprising the steps, in this sequence, of
a) providing a low-voltage electrode (80) comprising a circumferential wall (50) forming an elongated cavity (30), the circumferential wall comprising a mesh of conductive wires forming a plurality of apertures (60) between the conductive wires to allow a casting material (90) outside the circumferential wall to be mechanically connected with the casting material in the cavity while the casting material solidifies and thereafter; and
b) embed the low-voltage electrode in an electrically insulating flowable, solidifiable casting material (90) by making the casting material flow into the cavity (30) through the apertures (60).
